# EUROPEAN PATENT APPLICATION

(11) **EP 4 826 448 A1**
(43) Date of publication of application: **21.10.2026**
(21) Application number: 26172490.0
(22) Date of filing: 15.04.2026
(51) Int. Cl.: G03F 7/00, H10P 72/76

(54) **SUBSTRATE PROCESSING APPARATUS AND ARTICLE MANUFACTURING METHOD**

(30) Priority: 18.04.2025 JP 2025068956
(71) Applicant: Canon Kabushiki Kaisha, Tokyo 146-8501 (JP)
(72) Inventor: TAMURA, Koichi, Tokyo (JP)
(74) Representative: WESER & Kollegen Patentanwälte PartmbB

(57) **Abstract**

A substrate processing apparatus comprises a stage (20) configured to hold a substrate (16); a hand (42, 43) configured to convey the substrate; and a controller (30) configured to control at least one of a substrate supply operation onto the stage by the hand and a substrate collection operation from the stage by the hand. A chuck (21) selected from among a plurality of types of chucks is mounted on the stage, and pins (22) configured to protrude from the chuck and support the substrate in the at least one are provided in the stage. The controller is configured to control, in accordance with the thickness of the chuck mounted on the stage, a height of the hand when inserting/removing the hand between the substrate on the pins and the chuck in the at least one.

## Description

### TECHNICAL FIELD

The present disclosure relates to a substrate processing apparatus and an article manufacturing method.

### BACKGROUND

A substrate processing apparatus that processes a substrate performs a supply operation of supplying a substrate onto a stage by a hand that conveys a substrate, and a collection operation of collecting the substrate from the stage by the hand (see Japanese Patent Laid-Open No. 2020-149012). For example, on the stage, a chuck that supports the substrate and pins that protrude from the chuck and supports the substrate can be provided. In the supply operation, after the substrate is conveyed (supplied) by the hand onto the pins protruding from the chuck, the hand is removed from between the substrate on the pins and the chuck, and the substrate is arranged on the chuck by decreasing the protrusion amount of the pins from the chuck. In the collection operation, after the substrate on the chuck is transferred onto the pins by causing the pins to protrude from the chuck, the hand is inserted between the substrate on the pins and the chuck, and the substrate is conveyed (collected) from the pins by the hand.

In recent years, with the diversification of device manufacturing methods (processes), the substrate processing apparatus sometimes handles substrates of various thicknesses, sizes, and materials. For example, an exposure apparatus serving as a substrate processing apparatus may perform exposure processing on a plurality of types of substrates having different thicknesses. In the exposure processing, the height of the substrate can be adjusted by driving the stage in a height direction (Z direction) so that the surface of the substrate is arranged at the height of an exposure image plane. On the other hand, the stage is often provided with only a minimum driving stroke in the height direction from the viewpoint of power performance and cost, and depending on the thickness of the substrate, it may be difficult to arrange the surface of the substrate at the height of the exposure image plane only by driving the stage in the height direction. As a method of solving this problem, the chuck of the stage is replaced so as to change the thickness of the chuck in accordance with the thickness of a processing target substrate.

### SUMMARY

If the thickness of the chuck mounted on the stage is changed, the clearance (interval) between the substrate on the pins and the chuck in the supply operation and/or the collection operation is accordingly changed. Therefore, depending on the thickness of the chuck mounted on the stage, when inserting/removing the hand between the substrate on the pins and the chuck in the supply operation and/or the collection operation, the hand may interfere with the substrate on the pins or the chuck.

The present disclosure provides a technique advantageous for appropriately conveying a substrate by a hand (substrate handler) in a substrate processing apparatus.

The present disclosure in its first aspect provides a substrate processing apparatus as specified in claim 1. Optional features are specified in claim 2 to 12.

The present disclosure in its second aspect provides an article manufacturing method as specified in claim 13.

Features of the present disclosure will become apparent from the following description of embodiments with reference to the attached drawings. The following description of embodiments is described by way of example.

### BRIEF DESCRIPTION OF THE DRAWINGS

The accompanying drawings, which are incorporated in and constitute a part of the specification, illustrate embodiments of the present disclosure, and together with the description, serve to explain the principles of the embodiments.
Figs. 1A and 1B are schematic views showing an example of the configuration of an exposure apparatus according to the first embodiment;
Fig. 2 is a schematic view showing an example of the configuration of a substrate stage according to the first embodiment;
Figs. 3A and 3B are views each showing an example in which one of a plurality of types of substrates is arranged on a chuck;
Figs. 4A and 4B are views each for explaining a clearance generated between the substrate on pins and the chuck;
Fig. 5 is a flowchart illustrating the operation of the exposure apparatus according to the first embodiment;
Figs. 6A to 6F are schematic views showing a method of measuring the protrusible amount of the pins;
Figs. 7A and 7B are timing charts respectively showing the temporal transition of the exhaust pressure of the chuck and the temporal transition of the position (height) of the chuck;
Fig. 8 is a view for explaining an example of deciding the insertion/removal height of a hand;
Fig. 9 is a schematic view showing an example of the configuration of an exposure apparatus (conveyance unit) according to the second embodiment; and
Fig. 10 is a flowchart illustrating a chuck replacement operation according to the second embodiment.

### DESCRIPTION OF THE EMBODIMENTS

Hereinafter, embodiments will be described in detail with reference to the attached drawings. Note, the following embodiments are not intended to limit the scope of the claims. Multiple features are described in the embodiments, but it is not the case that all such features are required, and multiple such features may be combined as appropriate. Furthermore, in the attached drawings, the same reference numerals are given to the same or similar configurations, and redundant description thereof is omitted.

In the specification and the accompanying drawings, directions will be indicated on an XYZ coordinate system in which directions parallel to the surface of a substrate are defined as the X-Y plane. Directions parallel to the X-axis, the Y-axis, and the Z-axis of the XYZ coordinate system are the X direction, the Y direction, and the Z direction, respectively. A rotation about the X-axis, a rotation about the Y-axis, and a rotation about the Z-axis are θX, θY, and θZ, respectively. Control or driving concerning the X-axis, the Y-axis, and the Z-axis means control or driving concerning a direction parallel to the X-axis, a direction parallel to the Y-axis, and a direction parallel to the Z-axis, respectively. In addition, control or driving concerning the θX-axis, the θY-axis, and the θZ-axis means control or driving concerning a rotation about an axis parallel to the X-axis, a rotation about an axis parallel to the Y-axis, and a rotation about an axis parallel to the Z-axis, respectively. In addition, a position is information that can be specified based on coordinates on the X-, Y-, and Z-axes, and a posture is information that can be specified by values on the θX-, θY-, and θZ-axes.

A substrate processing apparatus according to the present disclosure is an apparatus that processes a substrate, and includes a lithography apparatus, a measurement apparatus, and an inspection apparatus. The lithography apparatus includes, for example, an exposure apparatus, an imprint apparatus, a planarization apparatus, and a drawing apparatus, and forms a pattern on a substrate as processing of the substrate. The exposure apparatus exposes a substrate by projecting the pattern of an original (mask or reticle) to the substrate. The imprint apparatus shapes an imprint material on a substrate using an original (mold) having a concave-convex pattern, thereby forming the pattern on a composition (imprint material) on the substrate. The planarization apparatus planarizes a composition on a substrate using an original (mold) having a flat surface. The drawing apparatus draws a pattern on a substrate using a charged particle beam (electron beam, ion beam, or the like). The measurement apparatus includes an alignment measurement apparatus used to align an original and a substrate. The inspection apparatus includes an overlay inspection apparatus that inspects the overlay precision of a pattern formed on a substrate. An exposure apparatus will be exemplified below as a substrate processing apparatus.

### <First Embodiment>

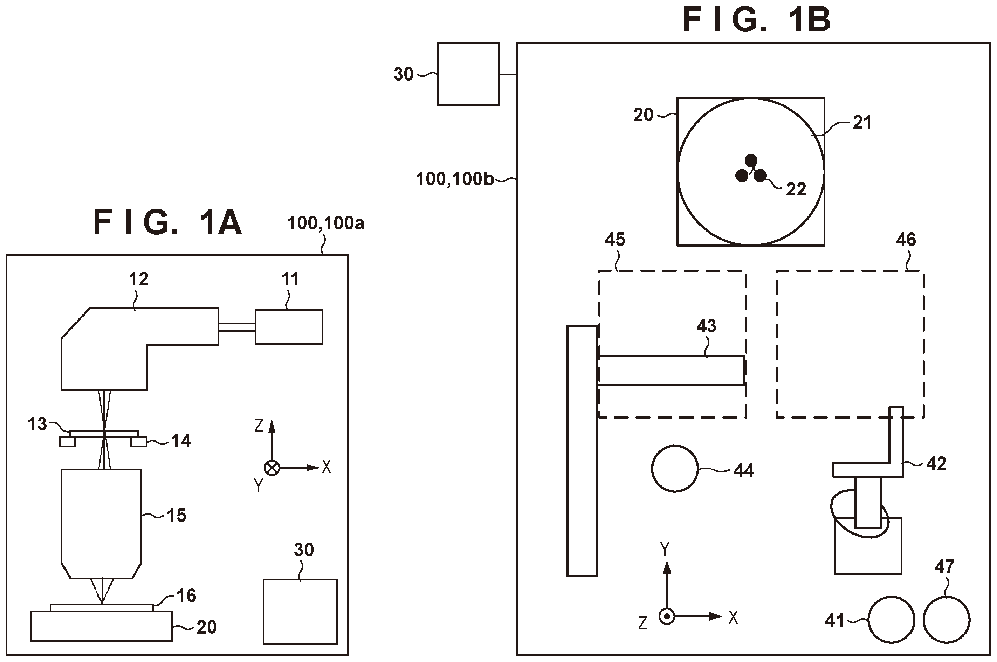

The first embodiment according to the present disclosure will be described. Figs. 1A and 1B are schematic views showing an example of the configuration of an exposure apparatus 100 as a substrate processing apparatus according to this embodiment. The exposure apparatus 100 is one of lithography apparatuses for forming a pattern on a substrate in a step of manufacturing a device such as a semiconductor element or a liquid crystal display element, and transfers a pattern of an original 13 onto a substrate 16 by exposing the substrate 16 via the original 13.

First, an example of the configuration of a forming unit 100a that forms a pattern on the substrate 16 in the exposure apparatus 100 according to this embodiment will be described. Fig. 1A shows an example of the configuration of the forming unit 100a in the exposure apparatus 100 according to this embodiment. As shown in Fig. 1A, the forming unit 100a according to this embodiment can include an illumination optical system 12, an original stage 14, a projection optical system 15, a substrate stage 20, and a controller 30.

The illumination optical system 12 shapes, in a predetermined shape suitable for exposure, light (exposure light) from a light source unit 11, and uniformly illuminates the original 13 with the light. The original 13 is, for example, a mask or reticle, and can be made of quartz. On the original 13, a pattern (circuit pattern) to be transferred to the substrate 16 is formed. The original stage 14 holds the original 13 via an original chuck, and is driven by an original driving mechanism. The original driving mechanism includes a linear motor, and positions the original 13 held by the original stage 14 by driving the original stage 14.

The projection optical system 15 is an optical system that images the light from an object plane onto an image plane. The projection optical system 15 irradiates the substrate 16 with the light (diffracted light) having passed through the original 13, thereby projecting the pattern image of the original 13 to the substrate 16. The substrate 16 is a processing target object to which the pattern of the original 13 is transferred, and includes a wafer, a liquid crystal substrate, and another processing target substrate. A photosensitive agent (photoresist) is arranged (applied) onto the substrate 16. The substrate stage 20 holds the substrate 16 via a chuck 21, and is driven by a substrate driving mechanism. The substrate driving mechanism includes a linear motor, and positions the substrate 16 held by the substrate stage 20 by driving the substrate stage 20.

The controller 30 is formed by a computer (information processing apparatus) including a processor such as a Central Processing Unit (CPU) and a storage unit such as a memory. The controller 30 operates the exposure apparatus 100 by comprehensively controlling the respective units of the exposure apparatus 100 in accordance with a program stored in the storage unit or the like.

In the forming unit 100a having the above-described configuration, the pattern image of the original 13 is projected to the substrate 16 via the projection optical system 15 by the light having passed through the original 13. The original 13 and the substrate 16 are arranged in an optically conjugate relationship with respect to the projection optical system 15. More specifically, the original 13 is arranged on the object plane of the projection optical system 15, and the substrate 16 is arranged on the image plane of the projection optical system 15. The pattern of the original 13 is transferred onto the substrate 16 by scanning the original 13 and the substrate 16 at a speed ratio corresponding to the projection magnification of the projection optical system 15.

Next, an example of the configuration of a conveyance unit 100b that conveys the substrate 16 in the exposure apparatus 100 according to this embodiment will be described. Fig. 1B shows an example of the configuration of the conveyance unit 100b in the exposure apparatus 100 according to this embodiment. The conveyance unit 100b conveys the substrate 16 among a loading port 41, the substrate stage 20, and an unloading port 47.

The substrate stage 20 can include the chuck 21 that supports the substrate 16, and pins 22 that protrude from the upper surface (substrate support surface) of the chuck 21 and support the substrate 16 in a supply operation and/or a collection operation. In this embodiment, the plurality (three in Fig. 1B) of pins 22 are provided, and are normally stored in the chuck 21. In the supply operation and/or the collection operation, the chuck 21 and the pins 22 are relatively driven so that the pins 22 protrude from the chuck 21. The supply operation is an operation of supplying the substrate 16 onto the substrate stage 20 by a second hand 43. The collection operation is an operation of collecting the substrate 16 from the substrate stage 20 by a first hand 42. The supply operation and the collection operation are performed by the different hands in this embodiment but may be performed by the same hand. Note that a description "supply operation and/or collection operation" may be understood to indicate at least one of the supply operation and the collection operation.

The chuck 21 and the pins 22 may be relatively driven by driving the chuck 21 with respect to the pins 22 or by driving the pins 22 with respect to the chuck 21. Alternatively, the chuck 21 and the pins 22 may be relatively driven with respect to each other. This embodiment will describe an example in which the chuck 21 and the pins 22 are relatively driven by driving the chuck 21 with respect to the pins 22.

The substrate 16 is loaded into the conveyance unit 100b (exposure apparatus 100) via the loading port 41. The loading port 41 is a loading port for loading the substrate 16 from an external apparatus into the exposure apparatus 100, and may be understood as, for example, a placing table on which a container (for example, a Front Opening Unified Pod (FOUP)) containing the processing target substrate 16 is placed. The substrate 16 loaded into the conveyance unit 100b is conveyed, by the first hand 42, to a prealignment unit 44 (prealignment stage) that performs prealignment (coarse alignment) of the substrate 16. The prealignment unit 44 detects the outer peripheral position of the substrate 16 while rotating the substrate 16, thereby measuring the position of the substrate 16 in the X direction, the Y direction, and the θZ direction and the warping amount of the substrate 16. Note that the first hand 42 is a kind of conveyance mechanism that holds the substrate 16 by vacuum suction or the like and conveys it.

The substrate 16 having undergone prealignment by the prealignment unit 44 is supplied (conveyed), by the second hand 43, onto the substrate stage 20 arranged at a supply location 45. That is, a supply operation of supplying the substrate 16 onto the substrate stage by the second hand 43 is performed. In the supply operation, the substrate 16 is supplied (passed) from the second hand 43 onto the pins 22 protruding from the chuck 21 by lowering the second hand 43 holding the substrate 16 from above the substrate stage 20. After the second hand 43 is removed from between the substrate 16 on the pins 22 and the chuck 21, the protrusion amount of the pins 22 from the chuck 21 is decreased to store the pins 22 in the chuck 21, thereby arranging, on the chuck 21, the substrate 16 on the pins. Thus, the substrate 16 is held by the substrate stage 20 (chuck 21). Furthermore, after or while storing the pins 22 in the chuck 21, the substrate stage 20 moves to a location where exposure processing is performed on the substrate 16. Note that the second hand 43 is a kind of conveyance mechanism that holds the substrate 16 by vacuum suction or the like and conveys it.

After the end of the exposure processing on the substrate 16, the substrate stage 20 holding the substrate 16 moves to a collection location 46. Then, the substrate 16 is collected, by the first hand 42, from the substrate stage 20 arranged at the collection location 46. That is, a collection operation of collecting the substrate 16 from the substrate stage 20 by the first hand 42 is performed. In the collection operation, after or in parallel to the movement of the substrate stage 20 to the collection location 46, the pins 22 are caused to protrude from the chuck 21. Thus, the substrate 16 is transferred from the chuck 21 onto the pins 22, and supported by the pins 22. In this state, the first hand 42 is inserted between the substrate 16 on the pins 22 and the chuck 21, and is raised, thereby collecting the substrate 16 on the pins 22 by the first hand 42. The substrate 16 collected from the pins 22 is conveyed to the unloading port 47 by the first hand 42. The unloading port 47 is an unloading port for unloading the substrate 16 from the exposure apparatus 100 to an external apparatus, and may be understood as, for example, a placing table on which a container (for example, a FOUP) containing the substrate 16 having undergone the exposure processing is placed.

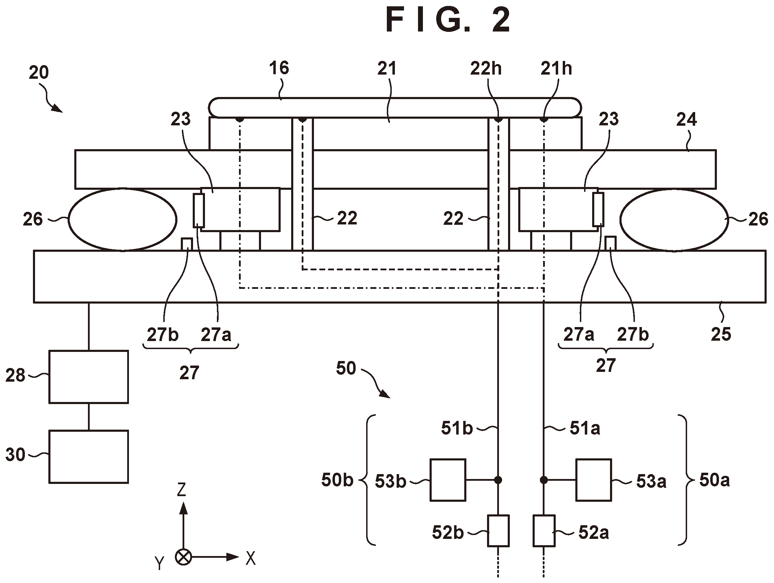

Next, examples of the configuration and operation of the substrate stage 20 will be described. Fig. 2 is a schematic view showing an example of the configuration of the substrate stage 20 according to this embodiment. As described above, the substrate stage 20 is provided with the chuck 21 that supports the substrate 16, and the pins 22 that protrude from the chuck 21 and support the substrate 16 in the supply operation and/or the collection operation. In addition, the substrate stage 20 includes a driver 23 that relatively drives the chuck 21 and the pins 22. The driver 23 according to this embodiment can include an actuator (for example, a linear motor) configured to drive the chuck 21 in the height direction (Z direction) with respect to the pins 22.

Furthermore, the substrate stage 20 can include an upper base 24 that supports the chuck 21, a lower base 25 to which the pins 22 are fixed, a support member 26 that supports the upper base 24, a position measurement device 27, and a driving controller 28.

The support member 26 is formed by, for example, an air spring that supports the upper base 24 by an air pressure, and can be arranged between the upper base 24 and the lower base 25. The support member 26 may be understood as a member that supports the chuck 21 supported by the upper base 24 and the pins 22 fixed to the lower base 25.

The position measurement device 27 measures the relative position between the chuck 21 and the pins 22 in the Z direction. In this embodiment, the position measurement device 27 includes an encoder formed by a scale 27a indirectly attached to the chuck 21 and a sensor 27b attached to the lower base 25, and can be configured to measure the position of the chuck 21 in the Z direction. However, the position measurement device 27 may be configured to measure the relative position between the chuck 21 and the pins 22 in the Z direction by another method such as a laser interferometer.

The driving controller 28 includes a processor such as a Central Processing Unit (CPU), and controls a command value (signal) sequentially supplied to the driver 23 to drive the chuck 21 with respect to the pins 22 under the control of the controller 30. For example, the driving controller 28 decides (calculates), based on the current position of the chuck 21 measured by the position measurement device 27, the command value to be supplied to the driver 23 so as to reduce the deviation between the current position and a driving target position. The command value is, for example, a current command value but may be a voltage command value or the like. Note that in this embodiment, the driving controller 28 is formed separately from the controller 30 but may be formed as a part of the controller 30.

The substrate stage 20 having the above configuration can increase the protrusion amount of the pins 22 from the chuck 21 and cause the pins 22 to protrude from the chuck 21 by driving (lowering) the chuck 21 in the -Z direction by the driver 23. For example, by causing the pins 22 to protrude from the chuck 21 in the collection operation, it is possible to transfer, onto the pins 22, the substrate 16 on the chuck 21. On the other hand, by driving (raising) the chuck 21 in the +Z direction by the driver 23, it is possible to decrease the protrusion amount of the pins 22 from the chuck 21 and store the pins 22 in the chuck 21. For example, by storing the pins 22 in the chuck 21 in the supply operation, it is possible to transfer, onto the chuck 21, the substrate 16 on the pins 22. In addition, the support member 26 supports the weight of the upper base 24, the chuck 21, and the substrate 16 by an air pressure like a rubber balloon, and expands or contracts in accordance with the movement of the chuck 21 in the Z direction.

The substrate stage 20 can be provided with an exhaust system 50 for holding the substrate 16 by vacuum suction. The exhaust system 50 includes a first exhaust unit 50a that exhausts the space on the chuck 21 to hold the substrate 16 by the chuck 21, and a second exhaust unit 50b that exhausts the space on the pins 22 to hold the substrate 16 by the pins 22. The first exhaust unit 50a and the second exhaust unit 50b can be controlled by the controller 30.

The first exhaust unit 50a can include an exhaust pipe 51a, an electromagnetic valve 52a, and a pressure sensor 53a. The exhaust pipe 51a makes an exhaust hole 21h formed on the upper surface (support surface) of the chuck 21 and a vacuum source (not shown) communicate with each other. The electromagnetic valve 52a is a valve that opens/closes the exhaust pipe 51a to control (turn on/off) holding of the substrate 16 by the chuck 21, and is provided on the exhaust pipe 51a between the exhaust hole 21h of the chuck 21 and the vacuum source. The pressure sensor 53a detects the internal pressure of the exhaust pipe 51a between the exhaust hole 21h of the chuck 21 and the electromagnetic valve 52a, that is, the exhaust pressure of the first exhaust unit 50a (to be sometimes referred to as "the exhaust pressure of the chuck 21" hereinafter).

For example, when supplying the substrate 16 to the chuck 21, the controller 30 opens the exhaust pipe 51a by the electromagnetic valve 52a, and also confirms, based on the detection result of the pressure sensor 53a, whether the exhaust pressure of the chuck 21 reaches a predetermined value. If the exhaust pressure of the chuck 21 is lower than the predetermined value, the controller 30 can determine that the substrate 16 is held by the chuck 21. By using an experiment, a simulation, or the like, the predetermined value can be preset to a pressure value (exhaust pressure) that can reduce the occurrence of misregistration of the substrate 16 with respect to the chuck 21. On the other hand, when collecting the substrate 16 from the chuck 21, the controller 30 closes the exhaust pipe 51a by the electromagnetic valve 52a.

The second exhaust unit 50b can include an exhaust pipe 51b, an electromagnetic valve 52b, and a pressure sensor 53b. The exhaust pipe 51b makes exhaust holes 22h formed on the upper surfaces (support surfaces) of the pins 22 and a vacuum source (not shown) communicate with each other. The electromagnetic valve 52b is a valve that opens/closes the exhaust pipe 51b to control (turn on/off) holding of the substrate 16 by the pins 22, and is provided on the exhaust pipe 51b between the exhaust holes 22h of the pins 22 and the vacuum source. The pressure sensor 53b detects the internal pressure of the exhaust pipe 51b between the exhaust holes 22h of the pins 22 and the electromagnetic valve 52b, that is, the exhaust pressure of the second exhaust unit 50b (to be sometimes referred to as "the exhaust pressure of the pins 22" hereinafter).

For example, when supplying the substrate 16 to the pins 22, the controller 30 opens the exhaust pipe 51b by the electromagnetic valve 52b, and also confirms, based on the detection result of the pressure sensor 53b, whether the exhaust pressure of the pins 22 reaches a predetermined value. If the exhaust pressure of the pins 22 is lower than the predetermined value, the controller 30 can determine that the substrate 16 is held by the pins 22. By using an experiment, a simulation, or the like, the predetermined value can be preset to a pressure value (exhaust pressure) that can reduce the occurrence of misregistration of the substrate 16 with respect to the pins 22. On the other hand, when collecting the substrate 16 from the pins 22, the controller 30 closes the exhaust pipe 51b by the electromagnetic valve 52b.

In recent years, with the diversification of device manufacturing methods (processes), the exposure apparatus 100 sometimes handles the substrates 16 of various thicknesses, sizes, and materials. For example, the exposure apparatus 100 may perform exposure processing on the plurality of types of substrates 16 having different thicknesses. In the exposure processing, the height of the substrate 16 can be adjusted by driving the chuck 21 in the height direction (Z direction) by the driver 23 so that the surface of the substrate 16 is arranged at the height of an exposure image plane (that is, the image plane of the projection optical system 15).

On the other hand, for the substrate stage 20, if the driving stroke of the chuck 21 in the height direction by the driver 23 is increased, the weight of the substrate stage 20 accordingly increases, which may influence the speed and accuracy when the substrate stage 20 moves in the X and Y directions, and the apparatus cost. Therefore, the driver 23 of the substrate stage 20 is often provided with only a minimum driving stroke in the height direction from the viewpoint of power performance and cost. In this case, depending on the thickness of the processing target substrate 16, it may be difficult to arrange the surface of the substrate 16 at the height of the exposure image plane only by driving the chuck 21 in the height direction by the driver 23. As a method of solving this problem, in this embodiment, the chuck 21 of the substrate stage 20 is replaced so as to change the thickness of the chuck 21 in accordance with the thickness of the processing target substrate 16.

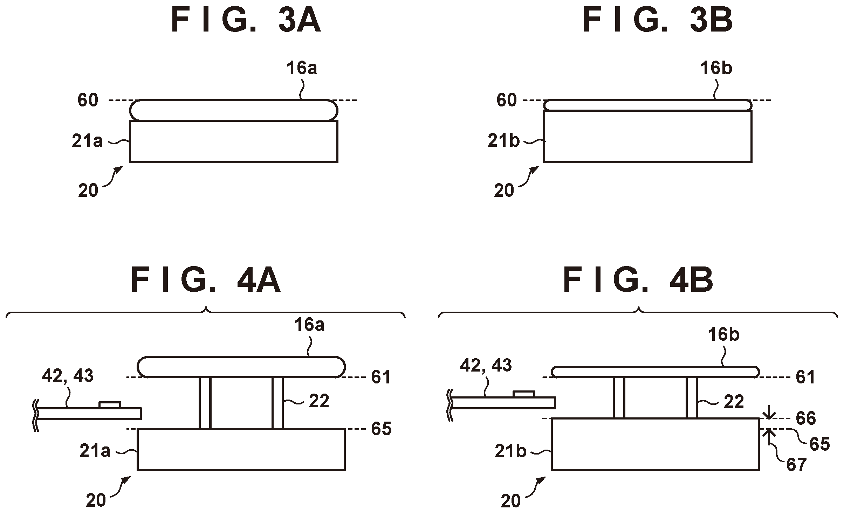

Figs. 3A and 3B each show an example in which one of the plurality of types of substrates 16 having different thicknesses is arranged on the chuck 21. Fig. 3A shows an example of using a first substrate 16a having a standard thickness. The standard thickness is, for example, 775 µm in a case where a 300 mm-diameter wafer is used as the first substrate 16a. In this case, a first chuck 21a having a reference thickness is mounted on the substrate stage 20. The first chuck 21a is configured so that when the lower base 25 is arranged at the upper limit height by the driver 23, the pins 22 are stored in the first chuck 21a and the upper surface of the first substrate 16a is arranged on an exposure image plane 60. On the other hand, Fig. 3B shows an example of using a second substrate 16b thinner than the first substrate 16a. In this case, a second chuck 21b thicker than the first chuck 21a is mounted on the substrate stage 20. The second chuck 21b is configured so that when the lower base 25 is arranged at the upper limit height by the driver 23, the upper surface of the second substrate 16b is arranged on the exposure image plane 60.

As described above, in this embodiment, the chuck 21 of the substrate stage 20 is replaced so that the thickness of the chuck 21 is changed in accordance with the thickness of the processing target substrate 16. However, if the thickness of the chuck 21 mounted on the substrate stage 20 is changed, the protrusion amount of the pins 22 from the chuck 21 in the supply operation and/or the collection operation changes accordingly. That is, the clearance (interval) between the substrate 16 on the pins 22 and the chuck 21 in the supply operation and/or the collection operation changes. Therefore, depending on the thickness of the chuck 21 mounted on the substrate stage 20, when inserting/removing the hand 42 or 43 between the substrate 16 on the pins 22 and the chuck 21, the hand 42 or 43 may interfere with the substrate 16 on the pins 22 or the chuck 21.

In this example, the protrusion amount of the pins 22 from the chuck 21 in the supply operation and/or the collection operation may be understood as the protrusible amount (maximum protrusion amount) of the pins 22 from the chuck 21, and will sometimes be referred to as "the protrusible amount of the pins 22" hereinafter. The protrusible amount of the pins 22 may be understood as the distance in the height direction between the upper ends (upper surfaces) of the pins 22 and the upper surface of the chuck 21 when the pins 22 maximally protrude from the chuck 21.

Figs. 4A and 4B are views each for explaining a clearance (interval) generated between the substrate 16 on the pins 22 and the chuck 21. Fig. 4A shows an example of using the first substrate 16a having the standard thickness and the first chuck 21a having the corresponding thickness. In this case, a clearance enough to insert/remove the hand 42 or 43 can be generated between the first substrate 16a (a lower surface 61) on the pins 22 and the first chuck 21a (an upper surface 65) when the lower base 25 is arranged at the lower limit height by the driver 23.

On the other hand, Fig. 4B shows an example of using the second substrate 16b thinner than the first substrate 16a and the second chuck 21b having the corresponding thickness. As described above, the second chuck 21b is thicker than the first chuck 21a. In this case, a clearance generated between the second substrate 16b (the lower surface 61) on the pins 22 and the second chuck 21b (an upper surface 66) when the lower base 25 is arranged at the lower limit height by the driver 23 is narrower by a difference 67 than in a case where the first chuck 21a is used. Therefore, if the hand 42 or 43 is inserted/removed between the second substrate 16b on the pins 22 and the second chuck 21b at the same height of the hand 42 or 43 as in the case where the first chuck 21a is used, the hand 42 or 43 may interfere with the second substrate 16b or the second chuck 21b.

Thus, if the thickness of the chuck 21 is changed, it is necessary to accordingly change the height of the hand 42 or 43 when inserting/removing the hand 42 or 43 between the substrate 16 on the pins 22 and the chuck 21. Especially, when the processing target substrate 16 warps or sags, it is desirable to increase the interval between the hand 42 or 43 and the substrate 16 on the pins 22 as much as possible, and it can be required to strictly adjust the height of the hand 42 or 43.

To cope with this, in the exposure apparatus 100 according to this embodiment, the chuck 21 selected, from the plurality of types of chucks 21 having different thicknesses, in accordance with the thickness of the processing target substrate 16 is mounted on the substrate stage 20. Then, in accordance with the thickness of the chuck 21 mounted on the substrate stage 20, the controller 30 controls the height of the hand 42 or 43 when inserting/removing the hand 42 or 43 between the substrate 16 on the pins 22 and the chuck 21 in the supply operation and/or the collection operation. This can reduce the possibility that the hand 42 or 43 interferes with the substrate 16 on the pins 22 or the chuck 21 in the supply operation and/or the collection operation.

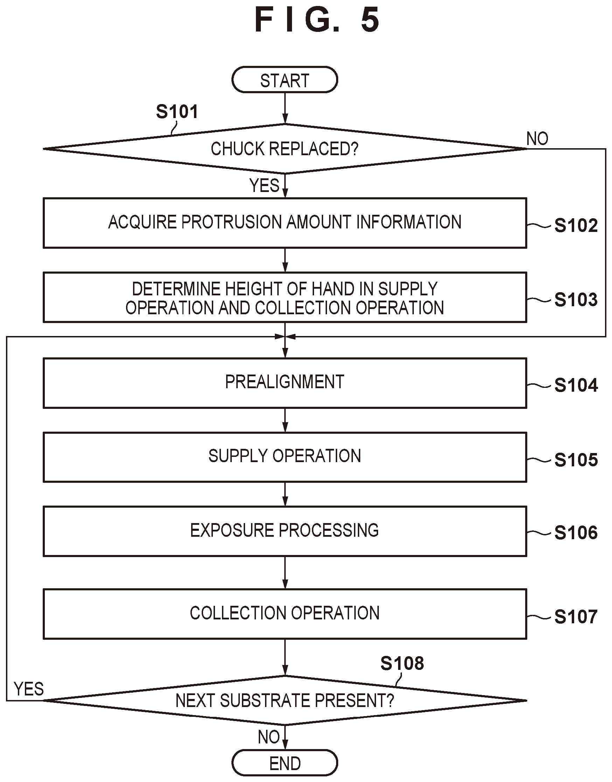

Fig. 5 is a flowchart illustrating the operation of the exposure apparatus 100 according to this embodiment. The flowchart shown in Fig. 5 is an operation procedure for processing the substrate 16, and can be executed by the controller 30. In the flowchart shown in Fig. 5, in the supply operation and/or the collection operation, the height (to be sometimes referred to as the "insertion/removal height" hereinafter) of the hand 42 or 43 when inserting/removing the hand 42 or 43 between the substrate 16 on the pins 22 and the chuck 21 is controlled.

In step S101, the controller 30 determines whether the chuck 21 is replaced on the substrate stage 20. For example, if a sensor that reads the identification information (ID) of the chuck 21 mounted on the substrate stage 20 is provided in the exposure apparatus 100, the controller 30 can determine, based on the identification information read by the sensor, whether the chuck 21 is replaced. Alternatively, if information (signal) indicating replacement of the chuck 21 is input via a user interface, the controller 30 can determine, based on the information, whether the chuck 21 is replaced. If the chuck 21 is replaced, the process advances to step S102. If the chuck 21 is not replaced, the process advances to step S104.

In step S102, the controller 30 acquires information (protrusion amount information) indicating the protrusible amount of the pins 22 from the chuck 21 in the supply operation and/or the collection operation. The protrusion amount information is information decided in accordance with the thickness of the chuck 21. For example, the controller 30 may manage (store) the protrusion amount information in linkage with the identification information of the chuck 21, and acquire the protrusion amount information in accordance with the identification information of the chuck 21 mounted on the substrate stage 20. Alternatively, the controller 30 may acquire the protrusion amount information by measuring the protrusible amount of the pins 22. A method of measuring the protrusible amount of the pins 22 will be described later.

In step S103, based on the protrusion amount information acquired in step S102, the controller 30 decides the insertion/removal height of the hand 42 or 43 in the supply operation and/or the collection operation. A method of deciding the insertion/removal height of the hand 42 or 43 will be described later. At this time, the controller 30 may manage (store) the relationship between the identification information of the chuck 21 and the insertion/removal height of the hand 42 or 43 to be applied to the chuck 21. In this case, in step S103, the controller 30 may decide the insertion/removal height of the hand 42 or 43 based on the identification information of the chuck 21 mounted on the substrate stage 20.

In step S104, the controller 30 conveys the substrate 16 from the loading port 41 to the prealignment unit 44 by the first hand 42, and performs prealignment of the substrate 16. Upon completion of the prealignment, the process advances to step S105, and the controller 30 collects the substrate 16 from the prealignment unit 44 by the second hand 43, and also executes the supply operation of supplying the substrate 16 onto the substrate stage 20 by the second hand 43. In the supply operation, based on the insertion/removal height decided in step S103, the height of the second hand 43 between the substrate 16 on the pins 22 and the chuck 21 is controlled.

Upon completion of the supply operation, the process advances to step S106, and the controller 30 executes the exposure processing on the substrate 16 on the substrate stage 20. After the end of the exposure processing, the process advances to step S107, and the controller 30 executes the collection operation of collecting the substrate 16 from the substrate stage 20 by the first hand 42, and conveys the substrate 16 to the unloading port 47 by the first hand 42. In the collection operation, based on the insertion/removal height decided in step S103, the height of the first hand 42 between the substrate 16 on the pins 22 and the chuck 21 is controlled.

In step S108, the controller 30 determines whether there is a substrate 16 (to be sometimes referred to as "the next substrate 16" hereinafter) to undergo the exposure processing next at the loading port 41. If there is the next substrate 16, the process returns to step S104, and steps S104 to S107 are executed on the next substrate 16. On the other hand, if there is no next substrate 16, the procedure ends.

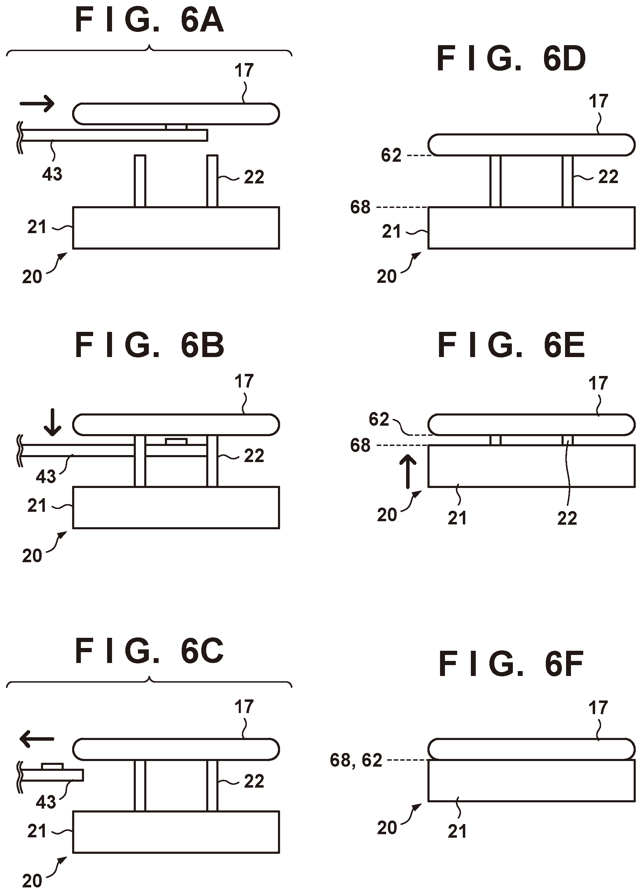

The method of measuring the protrusible amount of the pins 22 will be described next. Figs. 6A to 6F are schematic views showing the method of measuring the protrusible amount of the pins 22. In the measurement of the protrusible amount of the pins 22, a supply operation using a member 17 different from the substrate 16 can be performed. The member 17 is, for example, a plate member that has rigidity higher than that of the substrate 16 and is more difficult to warp than the substrate 16. The member 17 will sometimes be referred to as "the plate member 17" hereinafter. The plate member 17 may have the same outer diameter size as that of the substrate 16 and is preferably as flat as possible.

As shown in Fig. 6A, in a first state in which the pins 22 protrude from the chuck 21, the plate member 17 is arranged above the substrate stage 20 (pins 22) by the second hand 43. At this time, the lower base 25 is arranged at the lower limit height by the driver 23, and the pins 22 maximally protrude from the chuck 21. Then, as shown in Fig. 6B, the plate member 17 is supplied onto the pins 22 protruding from the chuck 21 by lowering the second hand 43.

After the plate member 17 is supplied onto the pins 22 and the second hand 43 and the plate member 17 are separated from each other, the second hand 43 is removed (retracted) from between the plate member 17 on the pins 22 and the chuck 21, as shown in Fig. 6C. It can be determined, based on the exhaust pressure of the pins 22 detected by the pressure sensor 53b, whether the second hand 43 and the plate member 17 are separated from each other. Since the plate member 17 is a flat member having high rigidity, as described above, even if the second hand 43 is moved near the plate member 17, the possibility that the second hand 43 and the plate member 17 interfere with each other is low.

Fig. 6D shows a state in which the second hand 43 is removed (retracted) from between the plate member 17 on the pins 22 and the chuck 21. Since the plate member 17 is a flat member, and the height of a lower surface 62 of the plate member 17 matches the height of the upper surfaces of the pins 22, the interval between the lower surface 62 of the plate member 17 and an upper surface 68 of the chuck 21 can correspond to the protrusible amount of the pins 22.

Next, the protrusion amount of the pins 22 from the chuck 21 is decreased by raising the chuck 21 by the driver 23, as shown in Fig. 6E, thereby bringing the plate member 17 and the chuck 21 into contact with each other, as shown in Fig. 6F. During this operation, a second state (timing) in which the plate member 17 and the chuck 21 start to contact each other is detected.

In the second state, the gap between the plate member 17 and the chuck 21 is eliminated, and the exhaust pressure of the chuck 21 changes. Therefore, the second state can be detected by monitoring the exhaust pressure of the chuck 21 using the pressure sensor 53a. In the second state, not only the chuck 21 but also the plate member 17 arranged on the chuck 21 starts to be driven by the driver 23, and a load applied to the driver 23 is the total of the weight of the chuck 21 and the weight of the plate member 17. Therefore, the deviation between the driving target position and the current position of the chuck 21 measured by the position measurement device 27 suddenly changes, and the command value supplied from the driving controller 28 to the driver 23 also suddenly changes. That is, the second state can also be detected by monitoring the deviation and the command value.

As described above, by relatively moving the chuck 21 and the pins 22 from the first state in which the pins 22 protrude from the chuck 21 to the second state in which the plate member 17 on the pins 22 and the chuck 21 start to contact each other, the moving amount can be measured as the protrusible amount. In this embodiment, by raising the chuck 21 from the first state to the second state by the driver 23, the moving amount (rise amount) of the chuck 21 can be measured as the protrusible amount.

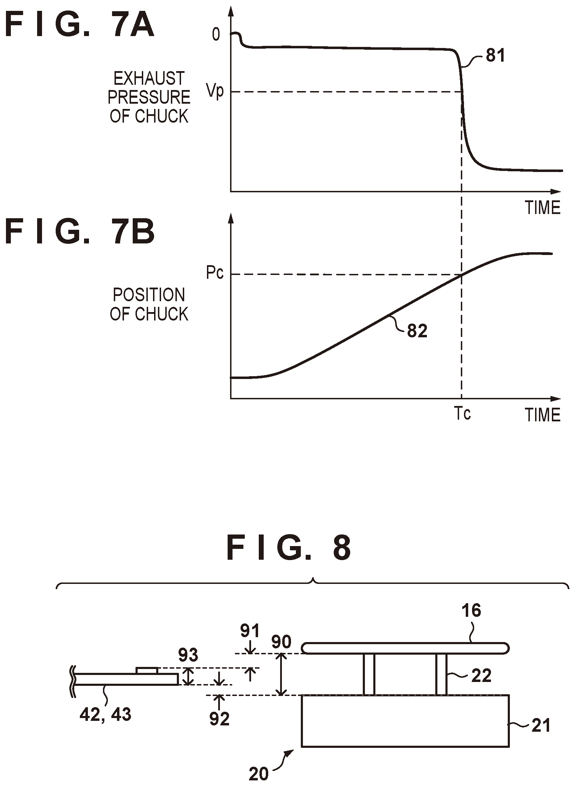

An example of measuring the protrusible amount of the pins 22 using the pressure sensor 53a will now be described. Fig. 7A shows a temporal transition 81 of the exhaust pressure of the chuck 21 detected by the pressure sensor 53a. Fig. 7B shows a temporal transition 82 of the position (height) of the chuck 21 measured by the position measurement device 27. In Figs. 7A and 7B, at the timing when the chuck 21 starts to rise in the first state in which the pins 22 protrude from the chuck 21, the exhaust pipe 51a is opened by the electromagnetic valve 52a to start to exhaust the space on the chuck 21 by the first exhaust unit 50a.

When the chuck 21 starts to rise, the plate member 17 and the chuck 21 are separated, and the first exhaust unit 50a is in a state of sucking air. Therefore, the exhaust pressure of the chuck 21 detected by the pressure sensor 53a indicates a value slightly lower than the atmospheric pressure. When the chuck 21 rises, the interval between the plate member 17 and the chuck 21 is narrowed accordingly, and the exhaust pressure of the chuck 21 starts to decrease immediately before the plate member 17 and the chuck 21 start to contact each other. When the plate member 17 and the chuck 21 start to contact each other, the exhaust pressure of the chuck 21 reaches a predetermined value Vp. That is, a timing Tc at which the exhaust pressure of the chuck 21 detected by the pressure sensor 53a reaches the predetermined value Vp can be determined as the timing of the second state in which the plate member 17 on the pins 22 and the chuck 21 start to contact each other. In addition, a position Pc of the chuck 21 at the timing Tc can be determined as the contact start position between the plate member 17 and the chuck 21. Therefore, the controller 30 can measure (decide), as the protrusible amount of the pins 22, the moving amount of the chuck 21 between the first state and the second state.

Note that a delay may occur from when the plate member 17 and the chuck 21 start to contact each other until the exhaust pressure of the chuck 21 reaches the predetermined value Vp. Thus, to accurately detect the second state, the driving speed of the chuck 21 by the driver 23 is set sufficiently low. Alternatively, the chuck 21 may be step-driven by a small distance while providing a time for confirming the exhaust pressure of the chuck 21 by the pressure sensor 53a. Furthermore, the timing Tc may be corrected by the delay time acquired in advance.

Next, the method of deciding the insertion/removal height of the hand 42 or 43 will be described. For example, the controller 30 can calculate, based on the protrusion amount information, the intermediate position in the height direction between the upper ends (upper surfaces) of the pins 22 and the chuck 21 (upper surface) when the lower base 25 is arranged at the lower limit height by the driver 23, and decide the intermediate position as the insertion/removal height of the hand 42 or 43. Alternatively, the controller 30 may calculate, based on the protrusion amount information, the height of the upper surface of the chuck 21 when the lower base 25 is arranged at the lower limit height by the driver 23, and decide, as the insertion/removal height of the hand 42 or 43, a position separated from the chuck 21 by a predetermined distance in the height direction. Furthermore, in a case where substrate information indicating the warping amount of the substrate 16 arranged on the pins 22 is acquired, the controller 30 may decide, based on the substrate information and the protrusion amount information, a position between the chuck 21 and the lower end of the substrate 16 on the pins 22 as the insertion/removal height of the hand 42 or 43. In this case, the controller 30 may decide the intermediate position between the chuck 21 and the lower end of the substrate 16 on the pins 22 as the insertion/removal height of the hand 42 or 43. The warping amount of the substrate 16 in the substrate information can be measured (decided or calculated) based on, for example, the measurement result of the prealignment unit 44.

Fig. 8 is a view for explaining an example of deciding the insertion/removal height of the hand 42 or 43. A thickness 93 (to be sometimes referred to as a "hand thickness 93" hereinafter) of the hand 42 or 43 is known, and a clearance 90 (interval) between the substrate 16 on the pins 22 and the chuck 21 is calculated based on the protrusion amount information. The controller 30 assigns a value obtained by subtracting the hand thickness 93 from the clearance 90 to a clearance 91 (upper clearance) between the hand 42 or 43 and the substrate 16 on the pins 22 and a clearance 92 (lower clearance) between the hand 42 or 43 and the chuck 21. This makes it possible to decide the insertion/removal height of the hand 42 or 43.

In a case where the substrate 16 is almost flat, the controller 30 can set the upper clearance 91 and the lower clearance 92 to the same value, and decide, as the insertion/removal height of the hand 42 or 43, the central position in the height direction between the substrate 16 on the pins 22 and the chuck 21. On the other hand, in a case where the substrate 16 warps or sags, the controller 30 preferably sets the upper clearance 91 to be larger than the lower clearance 92. In this case, as long as the thickness of the chuck 21 remains unchanged, the lower clearance 92 may be set to a constant value. That is, the lower clearance 92 can be set to a constant value in consideration of the tolerance for parallelism, bending, and vibration or the like when moving the hand 42 or 43.

For example, assume a case where the clearance 90 is 6.0 mm and the hand thickness 93 is 2.0 mm. When the central position between the substrate 16 on the pins 22 and the chuck 21 is set as the insertion/removal height of the hand 42 or 43, each of the upper clearance 91 and the lower clearance 92 is 2.0 mm. If the lower clearance 92 is required to be 1.0 mm, the upper clearance 91 is set to 3.0 mm, thereby making it possible to reduce interference of the hand 42 or 43 with the warped or sagged substrate 16. By deciding the insertion/removal height of the hand 42 or 43, as described above, it is possible to reduce interference of the hand 42 or 43 even in a case where the thickness of the chuck 21 is changed.

In a case where the warping amount of the substrate 16 on the pins 22 is measured in advance, the insertion/removal height of the hand 42 or 43 may be variable. Assume, for example, a case where the clearance 90 is 6.0 mm, the hand thickness 93 is 2.0 mm, and the substrate 16 on the pins 22 sags by 0.6 mm from the upper end of the pins 22. In this case, a position where each of the upper clearance 91 and the lower clearance 92 is 1.7 mm is preferably decided as the insertion/removal height of the hand 42 or 43. This can reduce interference of the hand 42 or 43 with the warped or sagged substrate 16 on the pins 22.

As described above, the exposure apparatus 100 according to this embodiment controls the height of the hand 42 or 43 in the supply operation and/or the collection operation in accordance with the thickness of the chuck 21 mounted on the substrate stage 20. Thus, it is possible to reduce the possibility that the hand 42 or 43 interferes with the substrate 16 on the pins 22 or the chuck 21 in the supply operation and/or the collection operation, and to appropriately convey the substrate 16 by the hand 42 or 43.

### <Second Embodiment>

The second embodiment according to the present disclosure will be described. In this embodiment, an example in which a replacement mechanism 48 that replaces a chuck 21 of a substrate stage 20 is provided in an exposure apparatus 100 will be described. Note that this embodiment basically inherits the first embodiment and can comply with the first embodiment, unless otherwise specified.

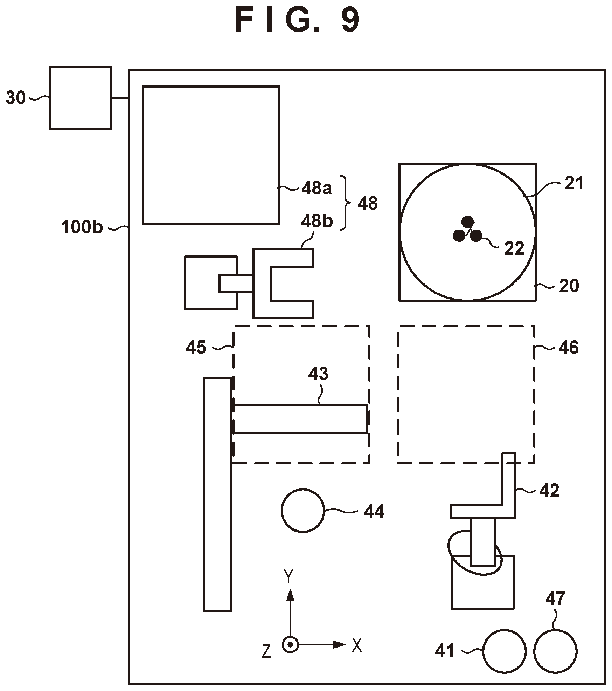

Fig. 9 is a schematic view showing an example of the configuration of the exposure apparatus 100 (a conveyance unit 100b) as a substrate processing apparatus according to this embodiment. In the conveyance unit 100b according to this embodiment, the replacement mechanism 48 that replaces the chuck 21 of the substrate stage 20 is further provided. The replacement mechanism 48 includes a chuck carrier 48a that stores a plurality of types of chucks 21 having different thicknesses, and a third hand 48b that conveys the chuck 21 between the chuck carrier 48a and the substrate stage 20. The third hand 48b is a kind of conveyance mechanism that holds the chuck 21 by vacuum suction or the like and conveys it, and can be configured to automatically perform a chuck replacement operation based on a command from a controller 30. Note that a forming unit 100a in the exposure apparatus 100 according to this embodiment is as described in the first embodiment, and a description thereof will be omitted.

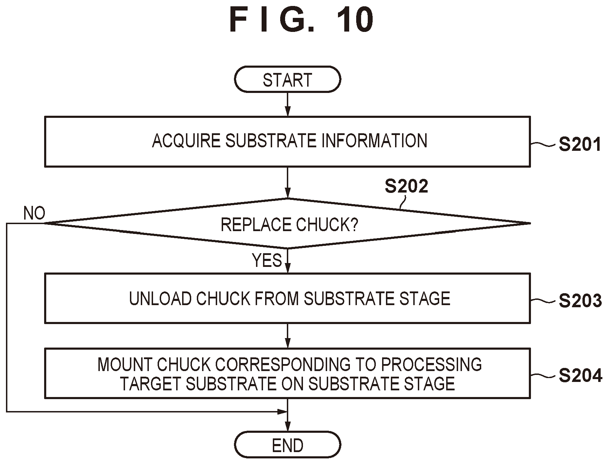

Fig. 10 is a flowchart illustrating a chuck replacement operation according to this embodiment. The flowchart shown in Fig. 10 can be executed by the controller 30. After the end of the flowchart shown in Fig. 10, the exposure apparatus 100 according to this embodiment can execute an operation for processing a substrate 16 in accordance with the flowchart of Fig. 5.

In step S201, the controller 30 acquires substrate information concerning the substrate 16 (processing target substrate 16) to undergo exposure processing. The substrate information is information including the thickness, size (dimensions), and material of the processing target substrate 16, and can be provided to the controller 30 via, for example, a user interface.

In step S202, the controller 30 determines, based on the substrate information acquired in step S201, whether to replace the chuck 21 of the substrate stage 20. For example, the controller 30 determines, based on the thickness information of the substrate 16 included in the substrate information, whether the chuck 21 (to be sometimes referred to as the "corresponding chuck 21" hereinafter) of a type (thickness) corresponding to the thickness information has already been mounted on the substrate stage 20. If the corresponding chuck 21 has already been mounted on the substrate stage 20, it is determined not to replace the chuck 21, thereby ending the processing. On the other hand, if the corresponding chuck 21 has not been mounted on the substrate stage 20, the process advances to step S203.

In step S203, the controller 30 unloads the chuck 21 mounted on the substrate stage 20 from the substrate stage 20 by the third hand 48b. The chuck 21 unloaded from the substrate stage 20 by the third hand 48b is conveyed to the chuck carrier 48a by the third hand 48b. Next, in step S204, the controller 30 extracts, from the chuck carrier 48a by the third hand 48b, the corresponding chuck 21 stored in the chuck carrier 48a, and mounts the corresponding chuck 21 on the substrate stage 20 by the third hand 48b. This mounts, on the substrate stage 20, the chuck 21 having a thickness corresponding to the thickness of the processing target substrate 16, thereby ending the chuck replacement operation.

As described above, in this embodiment, the replacement mechanism 48 that automatically performs a chuck replacement operation is provided. Thus, the exposure apparatus 100 can appropriately replace the chuck 21 of the substrate stage 20 in accordance with the thickness of the processing target substrate 16. The replacement mechanism 48 according to this embodiment is provided with the chuck carrier 48a but the chuck carrier 48a need not be provided. For example, the chuck 21 unloaded from the substrate stage 20 can be conveyed to a chuck replacement port by the third hand 48b, the chuck 21 on the third hand 48b can be replaced by an operator, and then the replaced chuck 21 can be conveyed to the substrate stage 20 by the third hand 48b. The chuck replacement port may be understood as a position (port) at which it is possible to access the outside of the apparatus, for example, a position at which the operator can access the third hand 48b.

### <Embodiment of Article Manufacturing Method>

An article manufacturing method according to the embodiment of the present disclosure is suitable to, for example, manufacture an article such as a microdevice such as a semiconductor device or an element having a microstructure. The article manufacturing method according to this embodiment includes a processing step of processing a substrate by using the above-described substrate processing apparatus (substrate processing method) and a manufacturing step of manufacturing an article from the substrate processed in the processing step. When the substrate processing apparatus is formed as an exposure apparatus, the processing step can include a step of exposing a substrate using the exposure apparatus, thereby forming a latent image pattern on a photoresist applied to the substrate. In addition, the processing step may include a step of developing the substrate on which the latent image pattern has been formed. The article manufacturing method further includes other known steps (oxidation, deposition, vapor deposition, doping, planarization, etching, resist removal, dicing, bonding, packaging, and the like). The article manufacturing method of this embodiment is more advantageous than conventional methods in at least one of the performance, quality, productivity, and production cost of the article.

### <Other Embodiments>

Embodiments of the present disclosure can also be realized by a computer of a system or apparatus that reads out and executes computer executable instructions (e.g., one or more programs) recorded on a storage medium (which may also be referred to more fully as a 'non-transitory computer-readable storage medium') to perform the functions of one or more of the above-described embodiment(s) and/or that includes one or more circuits (e.g., application specific integrated circuit (ASIC)) for performing the functions of one or more of the above-described embodiment(s), and by a method performed by the computer of the system or apparatus by, for example, reading out and executing the computer executable instructions from the storage medium to perform the functions of one or more of the above-described embodiment(s) and/or controlling the one or more circuits to perform the functions of one or more of the above-described embodiment(s). The computer may comprise one or more processors (e.g., central processing unit (CPU), micro processing unit (MPU)) and may include a network of separate computers or separate processors to read out and execute the computer executable instructions. The computer executable instructions may be provided to the computer, for example, from a network or the storage medium. The storage medium may include, for example, one or more of a hard disk, a random-access memory (RAM), a read only memory (ROM), a storage of distributed computing systems, an optical disk (such as a compact disc (CD), digital versatile disc (DVD), or Blu-ray Disc (BD)^{™}), a flash memory device, a memory card, and the like.

Various embodiments have been described in detail above but it will be understood that the present disclosure is not limited to these embodiments and encompasses all modifications, variants, alternatives and equivalents falling within the scope of the appended claims.

## Claims

1. A substrate processing apparatus that processes a substrate (16), comprising:
a stage (20) configured to hold the substrate;
a hand (42, 43) configured to convey the substrate; and
a controller (30) configured to control at least one of a supply operation of supplying the substrate onto the stage by the hand and a collection operation of collecting the substrate from the stage by the hand,
wherein a chuck (21) selected in accordance with a thickness of a processing target substrate from among a plurality of types of chucks having different thicknesses is mounted on the stage, and pins (22) configured to protrude from the chuck and support the substrate in the at least one operation are provided in the stage, and
wherein the controller is configured to control, in accordance with the thickness of the chuck mounted on the stage, a height of the hand when inserting/removing the hand between the substrate on the pins and the chuck in the at least one operation.

2. The apparatus according to claim 1, wherein the controller is configured to control, in accordance with the thickness of the chuck, the height of the hand so as to insert/remove the hand at an intermediate position between an upper end of the pins and the chuck in the at least one operation.

3. The apparatus according to claim 1, wherein the controller is configured to control, in accordance with the thickness of the chuck, the height of the hand so as to insert/remove the hand at a position separated from the chuck by a predetermined distance in the at least one operation.

4. The apparatus according to claim 1, wherein the controller is configured to acquire information indicating a warping amount of the substrate arranged on the pins, and control, in accordance with the thickness of the chuck and the warping amount of the substrate, the height of the hand so as to insert/remove the hand at a position between a lower end of the substrate and the chuck in the at least one operation.

5. The apparatus according to any one of claims 1 to 4, wherein
a protrusion amount by which the pins protrude from the chuck in the at least one operation changes in accordance with the thickness of the chuck mounted on the stage, and
the controller is configured to control the height of the hand based on information indicating the protrusion amount corresponding to the thickness of the chuck mounted on the stage.

6. The apparatus according to claim 5, wherein the controller is configured to measure, as the protrusion amount, a moving amount by which the chuck and the pins are relatively moved from a first state in which the pins protrude from the chuck to a second state in which the chuck and a member on the pins start to contact each other.

7. The apparatus according to claim 6, wherein
the chuck includes an exhaust pipe (51a) configured to exhaust a space on the chuck to hold the substrate, and
the controller is configured to detect the second state based on an internal pressure of the exhaust pipe.

8. The apparatus according to claim 6 or 7, wherein the controller is configured to measure the protrusion amount every time the chuck is replaced on the stage.

9. The apparatus according to any one of claims 6 to 8, wherein the member used in measurement of the protrusion amount is a plate member having rigidity higher than rigidity of the substrate.

10. The apparatus according to any one of claims 1 to 4, wherein the controller is configured to control the height of the hand based on identification information of the chuck mounted on the stage.

11. The apparatus according to any one of claims 1 to 10, further comprising a replacement mechanism (48) configured to replace the chuck on the stage.

12. The apparatus according to any one of claims 1 to 11, wherein processing of the substrate includes formation of a pattern on the substrate.

13. An article manufacturing method comprising:
processing a substrate using a substrate processing apparatus defined in any one of claims 1 to 12; and
manufacturing an article from the substrate processed in the processing.
